# EUROPEAN PATENT SPECIFICATION

(11) **EP 3 361 270 B1**
(45) Date of publication and mention of the grant of the patent: **26.06.2019**
(21) Application number: 17155322.5
(22) Date of filing: 09.02.2017
(51) Int. Cl.: G01R 27/02, G01R 29/24, G01R 31/02, H02S 50/00, H02S 50/10

(54) **METHOD AND DEVICE FOR FAST INSULATION MONITORING OF ELECTRICAL DEVICES HAVING LARGE GROUND CAPACITANCE**
VERFAHREN UND VORRICHTUNG ZUR SCHNELLEN ÜBERWACHUNG DER ISOLATION ELEKTRISCHER GERÄTE MIT GROSSER ERDKAPAZITÄT
PROCÉDÉ ET DISPOSITIF POUR SURVEILLER RAPIDEMENT L'ISOLATION DE DISPOSITIFS ÉLECTRIQUES AYANT UNE LARGE CAPACITÉ PAR RAPPORT À LA TERRE

(43) Date of publication of application: 15.08.2018
(73) Proprietor: ABB Schweiz AG, 5400 Baden (CH)
(72) Inventor: Kokkonen, Jesse, 00380 Helsinki (FI); Kohvakka, Kimmo, 00270 Helsinki (FI)
(74) Representative: Marks, Frank

(56) References cited:
- EP-A1- 0 654 673
- EP-A1- 2 721 423
- EP-A1- 2 746 789
- EP-A1- 3 109 647
- DE-A1-102012 019 094
- DE-A1-102015 102 310
- US-A1- 2012 014 020
- US-A1- 2017 016 951

## Description

### TECHNICAL FIELD

The present disclosure relates to electrical DC grids, more particularly, to a device and method of monitoring or measuring an insulation resistance between at least one conductor and ground of a system having a large ground capacitance between a conductor and ground. More particularly, it relates to methods and devices for measuring an insulation resistance in large photovoltaic generator systems, and the like.

### BACKGROUND OF THE INVENTION

Photovoltaic (PV) power plants are getting larger and larger, with the current largest unit sizes approaching power ratings of 4 MW. Having a 4 MW PV generator connected to a single inverter leads to new problems in the insulation monitoring field, resulting from the size of those systems and the related electrical capacitance. For example, the standard IEC 62109 requires that an insulation monitoring process must be executed on a PV generator before the inverter is allowed to connect to the power grid.

Insulation monitoring that is performed on a live circuit is usually carried out by injecting a bipolar DC voltage pulse between the live conductors (DC+ and DC-) of the PV generator and the ground. A pulse is typically injected to the live conductors by a Y-resistance connection, having a resistance between each of the connecting points (DC+, DC- and signal generator). The employed pulse voltage is commonly around 40 V DC. Due to the fact that the resistance value between DC+ and DC- is usually quite big, e.g., about 100 kOhm, the charging current due to the connected signal generator, and determined by this resistance value is necessarily small, and accordingly, the charging time for the ground capacitance present in the system also becomes longer for larger capacitance values.

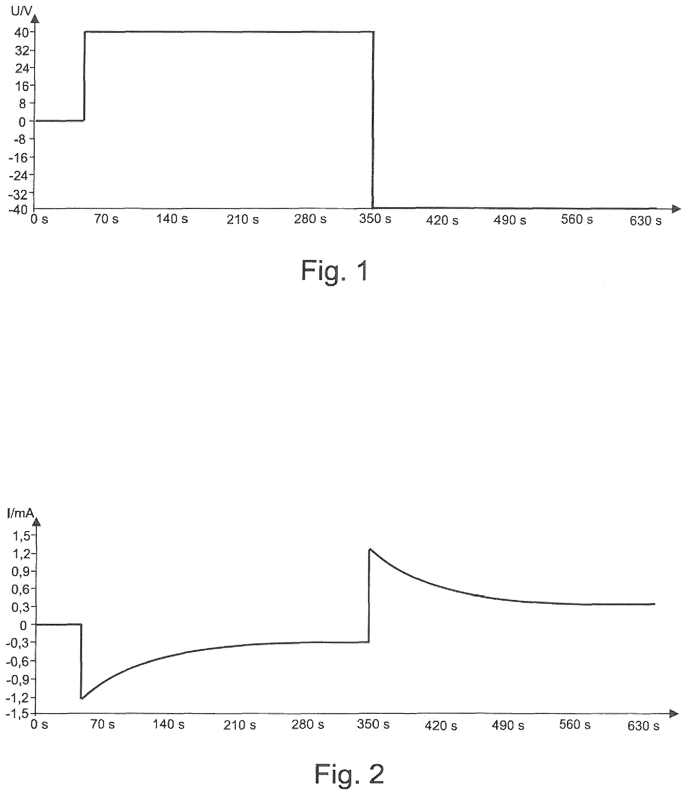

Insulation resistance is determined by measuring the current that flows from the signal generator to ground via the common DC circuit. To render the measurement more accurate, first the current is measured from one of the polarity pulses, then the polarity is changed, and the current is measured again. This is schematically shown in Fig. 1. The average of the two measured currents can be used for determining the insulation resistance. Optionally, many positive and negative pulses may be injected for more accurate determination of the insulation resistance.

Since a PV generator typically has a large ground capacitance between the DC lines and ground, the current fed by the DC voltage generator takes some time to stabilize. According to literature, polysilicon and monosilicon PV panels create about 150 nF/kWₚ of ground capacitance, whereas for thin film panels, the value can be about 1 µF/kWₚ. This results in a quite considerable ground capacitance value of 4 mF for a 4 MW PV generator having thin film panels.

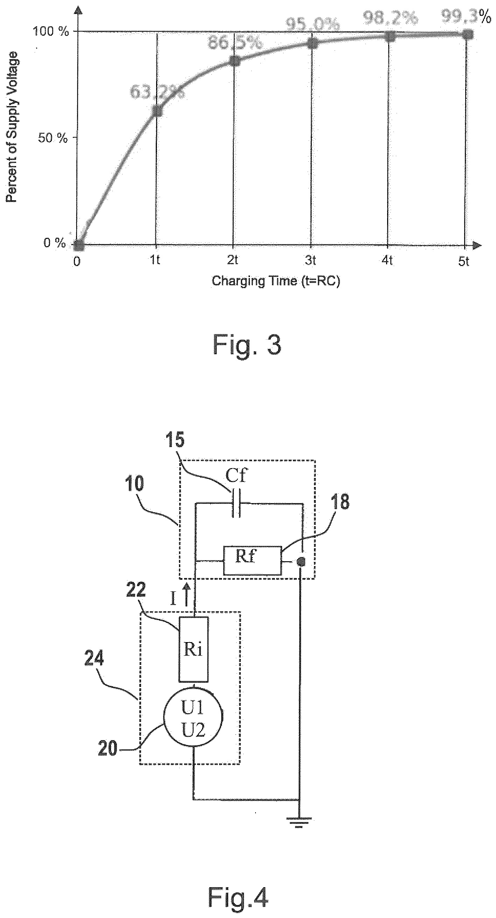

To charge an exemplary capacitor with 4 mF to the voltage value injected by the DC voltage generator can easily take minutes, or even tens of minutes, and since further, a bipolar pulse is needed for the measurement, the time required for determining the insulation resistance can take over an hour. An exemplary measurement is shown in Fig. 2, where the time until the charging current stabilizes is about 220 seconds. The charging time depends of course also on the power rating of the DC voltage generator, but due to the exponential form of any capacitor charging current, the time for the current to stabilize will always take a significant amount of time for large ground capacitance values, as can be seen in Fig. 3.

Prior art systems and methods according to the preamble of claims 1 and 9 can be found in EP0654673A1 and DE102015102310A1. Alternative systems and methods for accelerating measurement of an insulation resistance of a system having a ground capacitance are described in
EP3109647A1, EP2746789A1, DE102012019094A1 and US2017/016951A1.

As was shown, the known techniques leave room for improvement. In view of the above, there is a need for the present invention.

### SUMMARY OF THE INVENTION

In view of the above, a method for the measurement of an insulation resistance according to claim 1, and a testing device according to claim 9 are provided.

Further aspects, advantages and features of the present invention are apparent from the dependent claims, the description and the accompanying drawings.

### BRIEF DESCRIPTION OF THE DRAWINGS

A full and enabling disclosure, including the best mode thereof, to one of ordinary skill in the art is set forth more particularly in the remainder of the specification, including reference to the accompanying figures wherein:
Fig. 1 schematically shows a voltage over time which is applied to a circuit of which the insulation resistance shall be measured, according to a known method;
Fig. 2 schematically shows a current over time which is injected into a circuit of which the insulation resistance shall be measured, according to a known method;
Fig. 3 schematically shows a charging curve of an exemplary capacitor over time;
Fig. 4 shows an electrical equivalent circuit diagram for determining the insulation resistance of a system to be measured, according to embodiments;
Fig. 5a schematically shows the voltage applied to a system for which the insulation resistance shall be measured, according to embodiments;
Fig. 5b schematically shows the injected current into a system of which the insulation resistance shall be measured, according to embodiments;
Fig. 6 schematically shows a testing system according to embodiments.

### DETAILED DESCRIPTION OF THE INVENTION

Reference will now be made in detail to various embodiments, one or more examples of which are illustrated in each figure. Each example is provided by way of explanation and is not meant as a limitation. For example, features illustrated or described as part of one embodiment can be used on or in conjunction with other embodiments to yield yet further embodiments. It is intended that the present disclosure includes such modifications and variations.

Within the following description of the drawings, the same reference numbers refer to the same components. Generally, only the differences with respect to the individual embodiments are described. When several identical items or parts appear in a figure, not all of the parts have reference numerals in order to simplify the appearance.

As used herein, the term "first voltage level" is used interchangeably with "higher voltage level" and "first higher voltage level", and the term "second voltage level" is used interchangeably with the term "lower voltage level" and "second lower voltage level".

As used herein, the terms "higher voltage level" and "lower voltage level" are used to describe the relation of two or more voltage levels with respect to each other, and are hence to be interpreted relatively. The terms are not intended to have any meaning with respect to a hint on the absolute values or levels of the respective voltages, and should not be interpreted in that manner.

As used herein, the term "voltage pulse" is intended to mean a timely limited occurrence of a defined voltage with a defined length. Thereby, there is no limitation with respect to an absolute length of the pulse, which could, as non-limiting examples, have a duration from about 0.1 second up to about 60 minutes, including, as examples, 10 seconds, 30 seconds, 45 seconds, 60 seconds, and 2 minutes.

As used herein, the terms "pulse generator" and "voltage generator" and "DC voltage generator" are used interchangeably. They are intended to mean devices providing a voltage pulse in the above defined manner, wherein the duration of a timely limited application of a voltage, also called voltage pulse, can be defined, i.e. limited, by the device, no matter if this is initiated or carried out manually or in an automated way.

As used herein, the term "large ground capacitance" or "high ground capacitance" is intended to mean a ground capacitance of about 5 µF or larger.

Generally, embodiments disclosed herein are based on the concept that a first, higher voltage level pulse is injected to the system to be measured. When, or as soon as, the state of charge of the ground capacitance has reached a charging level which is equal to the level which would be reached when the lower voltage level would be applied, the DC voltage generator switches to the lower voltage level. By doing so, the charging is reduced to zero, and the injected current is stabilized - at a value determined by the insulation resistance - after switching to the lower voltage level, and thus the insulation measurement can be determined faster from the remaining injected current. Since the voltage of the voltage supply and the injected current are known, the insulation resistance can be determined therefrom by using Ohms law.

In Fig. 4, an electrical equivalent circuit diagram for determining the insulation resistance 18 (also: Rf) of a system 10, according to embodiments, is depicted. Therein, a DC voltage generator 20 is configured to deliver - according to a schedule described below - at least two different voltages, a higher voltage level U1 first applied during a measurement, and a lower voltage level U2. The voltage generator 20 is typically part of a testing device 24 which is described in greater detail with respect to Fig. 7 further below. The system 10 to be measured has a ground capacitance 15. The insulation resistance of the system 10, meaning from a live conductor to ground, is symbolized by Resistor Rf. When capacitor 15, and thus the ground capacitance 15, is completely charged, the current I injected by DC voltage generator 20 into the system 10 is determined almost entirely by the value of the insulation resistance Rf. The insulation resistance can thus be determined from the value of the lower voltage level U2 and the injected current I. I may typically be measured internally in the DC voltage generator 20, e.g. by measuring the voltage over an internal resistor 22 with value Ri in the DC voltage generator 20. Also, an additional measurement resistor (not shown) may be switched between the output of DC voltage generator 20 and the system 10. Further, the current I may in embodiments be determined by a measuring module 50 as part of a testing system 10, of which the DC voltage generator 20 is a part.

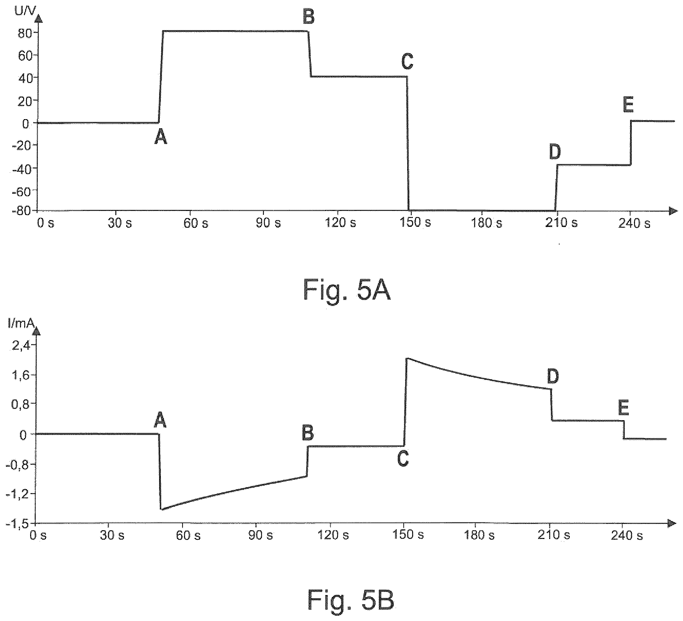

In Fig. 5a, the voltage fed by a DC voltage generator 20 to a tested system 10 is depicted, according to a method for the measurement of an insulation resistance of a system with a large ground capacitance. In Fig. 5b below Fig. 5a, on the same corresponding time scale with corresponding markers A, B, C, D, the current I injected into system 10 is depicted. A measurement cycle according to the method starts at index A, from where a first, higher voltage level U1 (in the example of Fig. 5a: 80 Volts) is supplied to the system 10, resulting in injecting a current I into the system 10 and in charging the ground capacitance 15 (cf. also Fig. 4). Thereby, the current I decreases (see Fig. 5b) between A and B due to the growing charge amount in the ground capacitance 15. During application of U1 (from index A to index B), the charging state of the ground capacitance is frequently or continuously determined. At index B, the boundary condition is met, and the DC voltage generator 20 switches from supplying the higher voltage level U1 to supplying the second, lower voltage level U2 (40 Volts) to the system 10. Thereby, the boundary condition is defined in that the determined charging state of the ground capacitance 15, at the higher voltage level U1 has a value which corresponds to a fully charged state of the ground capacitance 15 at the lower voltage level U2. Consequently, after the switching at index B to lower voltage level U2 (40 Volts), the injected current I remains constant - as the ground capacitance is fully charged at U2 and consequently, the current injected into system 10 is no longer influenced by the charging of the ground capacitance 15, but the remaining current is the leakage current determined by the value of the insulation resistance Rf. Thus, the measured current at the lower voltage level U2 between index B and C is employed to determine the value Rf of the insulation resistance 18 of the system 10 under test.

As shown in Fig. 5a and Fig. 5b, starting at index C, the higher voltage U1 is applied to the tested system 10 with reversed polarity, in comparison to the measurement cycle described above. Thus, basically the same measurement cycle is applied again with reversed polarity of the voltages U1 and U2. The values for the insulation resistance derived from both cycles may then be averaged in order to increase precision. Applying this second measurement, according to embodiments, with reversed polarity is a purely optional step, which increases precision, but prolongs the duration until the testing of system 10 is completed.

Typically, but not necessarily, the higher voltage level U1 is at least 70 % higher than the lower voltage level U2, more preferably from about 100 %, or even more, higher than the lower voltage level U2. The higher voltage level U1 is typically at least about 60 Volt.

Due to the fact that output voltages from, e.g., a photovoltaic generator can reach up to 1.500 V DC, measuring the voltage over the ground capacitance can be difficult - especially as the voltages U1 and U2 are typically relatively small in comparison. Also, voltage measurement from the live conductors would require the usage of resistance chains in order to lower the measurement level. Also, the ground capacitor voltage varies depending on the insulation resistance, and therefore, there is no fixed value that could be used for determining the correct timing for switching the voltage level of the voltage generator.

The system 10 is typically a photovoltaic (PV) generator, but it may also be any other electrical device, be it a consumer or a generator, of which an insulation resistance shall be measured, typically towards ground, while it has a considerably large ground capacitance value.

The shortened measurement duration which is possible according to methods according to embodiments is due to the fact that firstly, the ground capacitance is charged for a certain time with a higher voltage level - until the charging state corresponds to a charging state which would result from the lower voltage level - and is then switched to the lower voltage level. Hence, after the switching, the charging current is reduced to zero, as the ground capacitance already has its full charge which corresponds to the lower voltage level. It goes without saying that the charging level at which the voltage is switched should be determined accurately. If the charging level after the switching would be too low, there would result a further charging at lower voltage level U2. On the other hand, if the switching would be carried out too late, the charging level resulting from higher voltage level U1 might already be too high, and an unloading current against voltage level U2 might result. Both variants would result in an unwanted situation, namely that there is still a current in or out of the ground capacitance, and thus delaying the determination of the value of the insulation resistance.

In order to correctly determine the charging level of the ground capacitance 15 for switching from the higher voltage level to the lower voltage level, some variants are proposed according to embodiments. Basically, this can be carried out by measuring the voltage of the ground capacitance. Alternatively or additionally, the charging level can be determined by measuring the current injected into the ground capacitance. According to some embodiments, the state of charge of the ground capacitance can be determined from the voltage generator current I, even when the ground capacitance value 15 or the value of the insulation resistance Rf varies. To this end, the derivative value dl/dt of the current is being observed when, or after, the voltage generator changes the voltage level from U1 to U2. When the dl/dt value is near or exactly zero after the switching, the insulation resistance can be determined, since the current is stabilized.

According to embodiments, which can be combined with other embodiments described herein, an optimal pulse length for the application of the higher voltage level U1 can be determined iteratively. This may be done by starting with a relatively short pulse length, and when switching to the lower voltage level U2, measuring the dl/dt value of the current. If dl/dt is positive, then the higher voltage level pulse length is increased. When the dl/dt value approaches zero or becomes zero, the optimal pulse length of the higher voltage level pulse is found.

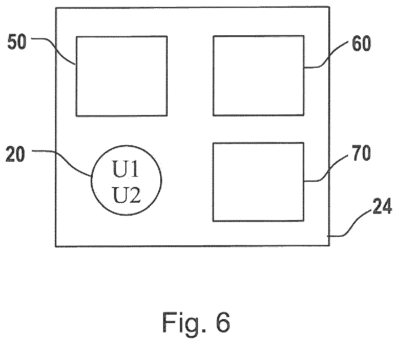

Fig. 6 shows a schematic block diagram of a testing device 24 according to embodiments. It is configured for determining the insulation resistance of a system 10 to be tested. Testing device 24 includes a DC voltage generator 20 configured to supply at least a higher voltage level U2 and a lower voltage level U1 to the system 10 (connectors to tested system not shown). A measuring module 50 is configured for measuring the current I injected into the tested system 10, cf. Fig. 4. A charge measuring module 60 serves for determining the charging state of the ground capacitance 15 of the tested system 10. Thereby, the charging state can be monitored by the charge measuring module 60 in several ways already described further above. Firstly, a deviation with respect to time of the current I injected into the system 10 may be determined, either continuously or in frequent intervals of, e.g., 0.1 seconds to 5 seconds. Also, a voltage of the ground capacitance 15 may be monitored, e.g. by frequently and shortly switching off the voltage from the voltage generator 20 and measuring the voltage of the system 10.

A control module 70 serves for controlling the operation of the testing device 24, so that it is configured to work in conjunction with the methods according to embodiments, which are described further above. It is understood that the above described modules and components of the testing device 24 may be arranged and configured differently without departing from the scope of this disclosure. Also, the various parts and modules may be arranged as single devices, or may be configured to be separate devices, in particular the voltage generator 20.

The control module 50, or a module with a similar functionality, of testing device 24 may typically include a data processing unit (not shown). The data processing unit may comprise a microcontroller, microprocessor or an ASIC, and at least one memory section for permanently and/or temporarily storing program code and data. The control module 50 is configured to control the testing device 24. To this end, the control module typically includes other elements like AD- and DA converters, and has interfaces to the voltage generator 20 and the other modules of the testing device 24.

In particular, the control module includes an algorithm, stored as program code and/or hardcoded in an ASIC, for example. The algorithm is configured to, when executed, make the testing device 24 perform actions and tasks which are part of the methods for the measurement of an insulation resistance of a system 10 having a large ground capacitance, according to embodiments, which are disclosed herein.

In particular, the testing device is typically configured to have, according to embodiments, one or more of the following features. As was described previously, the duration of application of the first, higher voltage U1, until it is switched to the lower voltage U2, can be adapted so that in the moment of switching, the boundary condition is met - which means that the actual charging state of the ground capacitance, at the higher voltage level U1, has a value which corresponds to a fully charged state of the ground capacitance at the lower voltage level U2. Hence, there is an optimal value for the duration of application of the first, higher voltage level U1 (or the pulse length of the pulse of that voltage level). It was laid out previously how it can be determined when the boundary condition is met, in particular by monitoring the deviation of the charging current with respect to time, during performing the testing method. In some embodiments, which can be combined with other embodiments disclosed herein, the testing device 24 may comprise data in a data base, which may be integrated with the control unit 50, about the ground capacitance values of at least one of: Previously tested systems, commercially available systems, or manually entered systems. Additionally or alternatively, testing device 24 may comprise an input device, such as a keyboard or keypad. For example, an operator may enter a ground capacitance value of a system to be tested, which is known from data provided by the manufacturer of the tested system.

Generally, testing system 24 may in embodiments be configured to be used in, or to perform various steps or tasks of, all methods according to embodiments described herein, including embodiments resulting from combinations of several embodiments described herein.

## Claims

1. A method for the measurement of an insulation resistance of a system (10) having a ground capacitance (15), the method comprising:
- providing a DC voltage generator (20), and connecting it to the system (10);
- supplying a first, higher voltage level to the system (10), thereby injecting a current into the system (10) and charging the ground capacitance (15);
- frequently or continuously determining the charging state of the ground capacitance (15);
- when a boundary condition is met, switching the DC voltage generator (20) from supplying the higher voltage level to supplying a second, lower voltage level to the system (10);
- measuring the current injected into the system (10) at the lower voltage level;
- determining the value of the insulation resistance of the device, based on the measured injected current at the lower voltage level, **characterised in that** the boundary condition is defined **in that** the actual charging state of the ground capacitance (15), at the higher voltage level, has a value which corresponds to a fully charged state of the ground capacitance (15) at the lower voltage level.

2. The method according to claim 1, wherein the higher voltage level is at least 70 % higher than the lower voltage level.

3. The method of any preceding claim, wherein at least after switching from the higher voltage level to the lower voltage level, the deviation of the current with respect to time is monitored.

4. The method of any preceding claim, wherein the charging state of the ground capacitance (15) is determined by monitoring the value of the deviation of the current with respect to time, and when the value is determined to be substantially zero, the value of the insulation resistance is determined.

5. The method according to any preceding claim, wherein the DC voltage generator (20) is connected to a live conductor of the system (10) and to a ground contact of the system.

6. The method of any preceding claim, wherein, after determining the insulation resistance of the system (10) based on the measured current, the polarity of the higher voltage level and the lower voltage level to ground is inverted, and the insulation resistance is again determined with the inverted voltage, and the average of both values is calculated.

7. The method of any preceding claim, wherein the higher voltage level is at least 60 Volt, and wherein the ground capacitance of the system is at least 100 µF.

8. The method of any preceding claim, wherein the system (10) is a photovoltaic generator.

9. A testing device (24) for determining an insulation resistance of a photovoltaic generator system (10) to be tested that has a large ground capacitance, comprising:
a DC voltage generator (20) configured to supply at least a higher voltage level and a lower voltage level to the system (10),
a measuring module (50) for measuring the current injected into the system (10), and
a charge measuring module (60) for determining the state of charge of the ground capacitance (15) of the system (10), preferably by monitoring a deviation with respect to time of the current injected into the system (10),
a control module (70) for controlling the operation of the testing device (24) according to a method of any of claims 1 to 9,
wherein the testing device is configured to switch from the higher voltage level to the lower voltage level when a boundary condition is met, **characterised in that** the boundary condition is defined **in that** the actual charging state of the ground capacitance (15), at the higher voltage level, has reached a value which corresponds to a fully charged state of the ground capacitance (15) at the lower voltage level.

10. The testing device of claim 9, wherein the higher voltage level is at least 70 % higher than the lower voltage level.

11. The testing device of claims 9 to 10, configured to, after switching from the higher voltage level to the lower voltage level, monitoring the deviation of the current with respect to time.

12. The testing device of claims 9 to 11, configured to determine a value for an insulation resistance, starting when a value of the deviation of the current with respect to time is determined to be substantially zero.

13. Use of a testing device (24) of any of claims 9 to 12 in determining the value of an insulation resistance (18) of a system (10).

## Patentansprüche

1. Verfahren zum Messen eines Isolationswiderstands eines Systems (10) mit einer Erdkapazität (15), wobei das Verfahren umfasst:
- Bereitstellen eines Gleichspannungsgenerators (20), und Anschließen davon an das System (10);
- Zuführen eines ersten, höheren Spannungspegels zu dem System (10), wodurch ein Strom in das System (10) injiziert und die Erdkapazität (15) aufgeladen wird;
- häufiges oder kontinuierliches Bestimmen des Ladezustands der Erdkapazität (15);
- wenn eine Randbedingung erfüllt ist, Schalten des Gleichspannungsgenerators (20) von Zuführen des höheren Spannungspegels zu Zuführen eines zweiten, niedrigeren Spannungspegels zu dem System (10);
- Messen des in das System (10) injizierten Stroms bei dem niedrigeren Spannungspegel;
- Bestimmen des Werts des Isolationswiderstands der Vorrichtung basierend auf dem gemessenen injizierten Strom bei dem niedrigeren Spannungspegel,
**dadurch gekennzeichnet, dass** die Randbedingung dadurch definiert ist, dass der tatsächliche Ladezustand der Erdkapazität (15) bei dem höheren Spannungspegel einen Wert aufweist, der einem voll aufgeladenen Zustand der Erdkapazität (15) bei dem niedrigeren Spannungspegel entspricht.

2. Verfahren nach Anspruch 1, wobei der höhere Spannungspegel mindestens 70 % höher als der niedrigere Spannungspegel ist.

3. Verfahren nach einem der vorhergehenden Ansprüche, wobei zumindest nach dem Schalten von dem höheren Spannungspegel zu dem niedrigeren Spannungspegel die Abweichung des Stroms in Bezug auf Zeit überwacht wird.

4. Verfahren nach einem der vorhergehenden Ansprüche, wobei der Ladezustand der Erdkapazität (15) durch Überwachen der Werts der Abweichung des Stroms in Bezug auf Zeit bestimmt wird, und wenn bestimmt wird, dass der Wert im Wesentlichen Null beträgt, der Wert des Isolationswiderstands bestimmt wird.

5. Verfahren nach einem der vorhergehenden Ansprüche, wobei der Gleichspannungsgenerator (20) an einen stromführenden Leiter des Systems (10) und an einen Massekontakt des Systems angeschlossen ist.

6. Verfahren nach einem der vorhergehenden Ansprüche, wobei nach Bestimmen des Isolationswiderstands des Systems (10) basierend auf dem gemessenen Strom die Polarität des höheren Spannungspegels und des niedrigeren Spannungspegels zu Masse umgekehrt wird, und der Isolationswiderstand erneut mit der umgekehrten Spannung bestimmt wird, und der Durchschnitt beider Werte berechnet wird.

7. Verfahren nach einem der vorhergehenden Ansprüche, wobei der höhere Spannungspegel mindesten 60 Volt ist, und wobei die Erdkapazität des Systems mindestens 100 µF ist.

8. Verfahren nach einem der vorhergehenden Ansprüche, wobei das System (10) ein Photovoltaikgenerator ist.

9. Prüfvorrichtung (24) zum Bestimmen eines Isolationswiderstands eines zu prüfendes Photovoltaikgeneratorsystems (10), das eine große Erdkapazität aufweist, umfassend:
einen Gleichspannungsgenerator (20), der ausgestaltet ist, mindestens einen höheren Spannungspegel und einen niedrigeren Spannungspegel zu dem System (10) zuzuführen,
ein Messmodul (50) zum Messen des in das System (10) injizierten Stroms, und
ein Ladungsmessmodul (60) zum Bestimmen des Ladezustands der Erdkapazität (15) des Systems (10), vorzugsweise durch Überwachen einer Abweichung in Bezug auf Zeit des in das System (10) injizierten Stroms,
ein Steuermodul (70) zum Steuern des Betriebs der Prüfvorrichtung (24) gemäß einem Verfahren nach einem der Ansprüche 1 bis 9,
wobei die Prüfvorrichtung ausgestaltet ist, von dem höheren Spannungspegel zu dem niedrigeren Spannungspegel zu schalten, wenn eine Randbedingung erfüllt ist, **dadurch gekennzeichnet, dass** die Randbedingung dadurch definiert ist, dass der tatsächliche Ladezustand der Erdkapazität (15) bei dem höheren Spannungspegel einen Wert erreicht hat, der einem voll aufgeladenem Zustand der Erdkapazität (15) bei dem niedrigeren Spannungspegel entspricht.

10. Prüfvorrichtung nach Anspruch 9, wobei der höhere Spannungspegel mindestens 70 % höher als der niedrigere Spannungspegel ist.

11. Prüfvorrichtung nach einem der Ansprüche 9 bis 10, die ausgestaltet ist, nach dem Schalten von dem höheren Spannungspegel zu dem niedrigeren Spannungspegel die Abweichung des Stroms in Bezug auf Zeit zu überwachen.

12. Prüfvorrichtung nach einem der Ansprüche 9 bis 11, die ausgestaltet ist, einen Wert für einen Isolationswiderstand zu bestimmen, beginnend wenn bestimmt wird, dass ein Wert der Abweichung des Stroms in Bezug auf Zeit im Wesentlichen Null beträgt.

13. Verwendung einer Prüfvorrichtung (24) nach einem der Ansprüche 9 bis 12 bei Bestimmen des Werts eines Isolationswiderstands (18) eines Systems (10).

## Revendications

1. Procédé de mesure de la résistance d'isolement d'un système (10) ayant une capacité à la masse (15), le procédé comprenant les étapes consistant à :
- préparer un générateur de tension continue (20) et le connecter au système (10) ;
- fournir un premier niveau de tension supérieur au système (10), injectant ainsi un courant dans le système (10) et chargeant la capacité à la masse (15) ;
- déterminer fréquemment ou en continu l'état de charge de la capacité à la masse (15) ;
- lorsqu'une condition limite est remplie, commuter le générateur de tension continue (20) de la fourniture du niveau de tension supérieur à la fourniture d'un second niveau de tension inférieur au système (10) ;
- mesurer le courant injecté dans le système (10) au niveau de tension inférieur ;
- déterminer la valeur de la résistance d'isolement du dispositif, sur la base du courant injecté mesuré au niveau de tension inférieur,
**caractérisé en ce que**
la condition limite est définie **en ce que** l'état de charge réel de la capacité à la masse (15), au niveau de tension supérieur, a une valeur qui correspond à un état complètement chargé de la capacité à la masse (15) au niveau de tension inférieur.

2. Procédé selon la revendication 1, dans lequel le niveau de tension supérieur est supérieur d'au moins 70% au niveau de tension inférieur.

3. Procédé selon l'une quelconque des revendications précédentes, dans lequel au moins après la commutation du niveau de tension supérieur au niveau de tension inférieur, la variation du courant par rapport au temps est surveillée.

4. Procédé selon l'une quelconque des revendications précédentes, dans lequel l'état de charge de la capacité à la masse (15) est déterminé en surveillant la valeur de la variation du courant par rapport au temps, et lorsqu'il est déterminé que la valeur est sensiblement égale à zéro, la valeur de la résistance d'isolement est déterminée.

5. Procédé selon l'une quelconque des revendications précédentes, dans lequel le générateur de tension continue (20) est connecté à un conducteur sous tension du système (10) et à un contact de masse du système.

6. Procédé selon l'une quelconque des revendications précédentes, dans lequel, après avoir déterminé la résistance d'isolement du système (10) sur la base du courant mesuré, la polarité du niveau de tension supérieur et du niveau de tension inférieur à la masse est inversée, et la résistance d'isolement est à nouveau déterminée avec la tension inversée et la moyenne des deux valeurs est calculée.

7. Procédé selon l'une quelconque des revendications précédentes, dans laquelle le niveau de tension supérieur est d'au moins 60 volts, et dans lequel la capacité à la masse du système est d'au moins 100 µF.

8. Procédé selon l'une quelconque des revendications précédentes, dans lequel le système (10) est un générateur photovoltaïque.

9. Dispositif de test (24) pour déterminer une résistance d'isolement d'un système de génération photovoltaïque (10) à tester ayant une grande capacité de masse, comprenant :
un générateur de tension continue (20) configuré pour fournir au moins un niveau de tension supérieur et un niveau de tension inférieur au système (10),
un module de mesure (50) pour mesurer le courant injecté dans le système (10), et
un module de mesure de charge (60) pour déterminer l'état de charge de la capacité à la masse (15) du système (10), de préférence en surveillant une variation par rapport au temps du courant injecté dans le système (10),
un module de commande (70) pour commander le fonctionnement du dispositif de test (24) conformément à un procédé selon l'une quelconque des revendications 1 à 9,
dans lequel le dispositif de test est configuré pour basculer du niveau de tension supérieur au niveau de tension inférieur lorsqu'une condition limite est remplie,
**caractérisé en ce que**
la condition limite est définie **en ce que** l'état de charge réel de la capacité à la masse (15), au niveau de tension supérieur, a atteint une valeur qui correspond à un état complètement chargé de la capacité à la masse (15) au niveau de tension inférieur.

10. Dispositif de test selon la revendication 9, dans lequel le niveau de tension supérieur est supérieur d'au moins 70% au niveau de tension inférieur.

11. Dispositif de test selon les revendications 9 à 10, configuré pour, après la commutation du niveau de tension supérieur au niveau de tension inférieur, surveiller la variation du courant par rapport au temps.

12. Dispositif de test selon les revendications 9 à 11, configuré pour déterminer une valeur pour une résistance d'isolement, à partir du moment où une valeur de la variation du courant par rapport au temps est déterminée comme étant sensiblement égale à zéro.

13. Utilisation d'un dispositif de test (24) selon l'une quelconque des revendications 9 à 12 pour déterminer la valeur d'une résistance d'isolement (18) d'un système (10) .
